# NEUE EUROPÄISCHE PATENTSCHRIFT

(11) **EP 0 632 847 B2**
(45) Veröffentlichungstag und Bekanntmachung des Hinweises auf die Entscheidung über den Einspruch: **25.08.2004**
(45) Hinweis auf die Patenterteilung: 27.12.1996
(21) Anmeldenummer: 93906594.2
(22) Anmeldetag: 24.03.1993
(51) Int. Cl.: C23C 14/02, C23C 14/20, C23C 14/58, B05D 5/06, C23C 28/00

(54) **VERFAHREN ZUM BESCHICHTEN EINES SUBSTRATS MIT EINEM EINE GLANZWIRKUNG HERVORRUFENDEN MATERIAL**
PROCESS FOR COATING A SUBSTRATE WITH A MATERIAL GIVING A POLISHED EFFECT
PROCEDE D'ENDUCTION D'UN SUBSTRAT AVEC UN MATERIAU PRODUISANT UN EFFET BRILLANT

(30) Priorität: 24.03.1992 DE 4209406
(43) Veröffentlichungstag der Anmeldung: 11.01.1995
(73) Patentinhaber: SCHWING, Thomas, D-36391 Sinntal-Mottgers (DE); SCHWING, Jürgen, D-36391 Sinntal-Mottgers (DE)
(72) Erfinder: SCHWING, Thomas, D-36391 Sinntal-Mottgers (DE); SCHWING, Jürgen, D-36391 Sinntal-Mottgers (DE)
(74) Vertreter: Stoffregen, Hans-Herbert, Dr. Dipl.-Phys.
(86) Internationale Anmeldenummer: PCT/EP1993/000704
(87) Internationale Veröffentlichungsnummer: WO 1993/019219

(56) Entgegenhaltungen:
- DE-A- 2 231 620
- DE-A- 2 620 878
- DE-A- 2 628 658
- DE-A- 2 743 670
- DE-A- 2 946 713
- DE-A- 3 333 381
- DE-A- 3 913 014
- FR-A- 2 534 278
- US-A- 4 849 283
- Metalloberfläche 45 (1991), 11, S 510, "Von der Nasslackierung auf elektrostatische Pulverbeschichtung umsteigen"
- Technische Lieferbedingungen TL239 der Volkswagengruppe
- Galvanotechnik 80 (1989), D-Saulgau, Heft 7, S. 2296-2299, Käszmann, "Die Entwicklung der Brille in 7 Jahrhunderten"
- Oberfläche + JOT, 1990, Heft 10, S 66-70, Anton, "Pulverbeschichtung am Alurad"

## Beschreibung

Die Erfindung bezieht sich auf ein Verfahren zum Beschichten eines Substrats mit einem eine Glanzwirkung hervorrufenden Material wie Metall, wobei das Substrat aus einem geeigneten Material besteht, welches bis zumindest 120 °C formbeständig ist.

Um auf Gegenständen einen Hochglanzeffekt zu erreichen, erfolgt nach dem Stand der Technik z. B. ein galvanisches Verchromen, Vernickeln oder Eloxieren. Hierbei sind aufwendige Vorbehandlungen des Grundmaterials notwendig wie z. B. Polieren der Oberfläche, um den gewünschten Hochglanzeffekt zu erzielen. Darüber hinaus können bestimmte Materialen nicht dauerhaft hochglanzmetallisiert werden, so z. B. Chrom auf Aluminium. Entsprechende Verfahren zeigen zudem den Nachteil, daß sie zu einer hohen Umweltbelastung führen.

Es ist auch bekannt, durch PVD- oder CVD-Verfahren in Verbindung mit einer Naßlackiertechnik eine Metallisierung zu erzielen, wobei jedoch in korrosionsgefährdeten Bereichen die erforderliche Haltbarkeit nicht erzielbar ist. Die mechanische und chemische Beständigkeit von Naßlacken ist für die Beschichtung von stark belasteten Teilen nicht ausreichend. Der Korrosionsschutz läßt häufig zu wünschen übrig. Auch ist aufgrund der Naßlackiertechnik eine unerwünschte Umweltbelastung gegeben.

Aus der DE 33 33 381 A1 ist ein Verfahren zur Herstellung einer Metallschicht auf eine hochwetterfeste Grundschicht aus Zweikomponenten-Polyurethanüberzug oder einem UV-Härtbarem Überzug durch Trockenplatierung, wie das Sputtern und die lonenplatierung, und Erzeugung einer Deckschicht durch Aufbringen eines Zweikomponenten-Polyurethanlacks oder eines UV-härtbaren Lacks mit hoher Wetterfestigkeit auf die Metallschicht bekannt. Das Verfahren bezieht sich lediglich auf KunstharzFormkörper. Zur Aufbringung des Metallglanzes ist es zwingend erforderlich, eine Grundschicht aus einem Zweikomponenten-Polyurethanüberzug oder einem UV-härtbaren Überzug auf die Oberfläche aufzubringen. Eine Farbgebung wird dabei entweder durch den Körper selbst oder durch die Grundschicht erzeugt.

Der vorliegenden Erfindung liegt das Problem zugrunde, ein Verfahren der eingangs genannten Art zur Verfügung zu stellen, wobei ohne Umweltbelastung eine Hochglanzmetallisierung einerseits grundsätzlich beliebigen Materials und andererseits nahezu jeder gewünschten Geometrie mit einer gleichmäßigen Güte erzielbar ist.

Das Problem wird durch ein Verfahren mit den Merkmalen des Anspruchs 1 gelöst.

Als Grundschicht wird eine Pulverlackschicht benutzt, die bei einer Substrattemperatur von in etwa 120 bis 240 °C eingebrannt wird. Die Einbrenndauer beläuft sich auf ca. 8 bis 30 Minuten.

Folglich können erfindungsgemäß Substrate beschichtet werden, die in dem angegebenen Temperaturbereich eine Verformung nicht zeigen. Zu diesen Materialien zählen z. B. Metall, Keramik, Glas, Kunststoffe, insbesondere faserverstärkte Kunststoffe etc..

Durch das Aufbringen der Grundschicht wird erreicht, daß die Substratoberfläche eben wird, d. h., daß auch rauhe Oberflächen ohne mechanische Behandlung "metallisiert" werden können; denn die einzubrennende Pulverlackschicht bewirkt eine Verschmierung der Oberfläche derart, daß gegebenenfalls ursprünglich vorhandene Rauhigkeiten abgedeckt werden.

Bei dem Pulver handelt es sich vorzugsweise um eine Polyester-Harz-Verbindung, wobei ein Abscheiden auf dem Substrat elektrostatisch erfolgt.

Sodann wird das die Glanzwirkung hervorrufende Material im Plasmaprozeß aufgetragen. Als Material kommen z. B. Aluminium, Chrom, Titan, Silber, Gold in Frage. Hierzu wird das Substrat in einen Reaktionsraum gebracht, in dem zunächst ein Druck von zumindest 10⁻⁴ mbar, vorzugsweise von 10⁻⁴ Millibar bis 10⁻⁵ Millibar aufgebaut wird. Hierdurch sollen insbesondere Sauerstoffmoleküle und Stickstoffmoleküle im erforderlichen Umfang entfernt werden. Anschließend wird der Reaktionsraum mit einem Prozeßgas (Inertgas oder Reaktivgas) geflutet, bis sich ein Druck zwischen 1 Millibar und 10⁻³ Millibar einstellt. Schließlich wird eine Glimmentladung gezündet, wobei sich ein Plasma ausbildet. In dieses Plasma wird sodann das den gewünschten Metalleffekt hervorrufende Metall verdampft, so daß auf das im Plasma befindliche Substrat das verdampfte Metall abgeschieden wird.

Das erforderliche Plasma kann durch Aufbau eines elektrischen Feldes zwischen einer Anode (Rezipient) und einer Kathode (Substrat) mittels Gleichspannung oder Hochfrequenz (kHz - MHz, vorzugsweise 13,56 MHz) innerhalb des Reaktionsraums, oder auch durch ein außerhalb des Reaktionsraums erzeugtes Hochfrequenzfeld (GHz, Mikrowelle) hervorgerufen werden.

Bei der Plasmaerzeugung durch Hochfrequenz ist darauf zu achten, daß die Substratoberfläche kleiner ist als die Rezipientenoberfläche, um eine ausreichende Polarisation der Elektroden zu gewährleisten.

Auch kann die Beschichtung mittels eines Lichtbogenverdampfers, Laserverdampfers oder durch Kathodenzerstäubung (Einfach- oder Doppelkathode) erfolgen. Bei dieser Art der Beschichtung entfällt eine separate Plasmaerzeugung, da das Plasma durch den Verdampfungs- oder Zerstäubungsprozeß erzeugt wird.

Die Deckschicht ist vom Aufbau und der Herstellung mit der Grundschicht vergleichbar, d. h., daß ein vorzugsweise aus einer Polyester-Harz-Verbindung bestehendes Pulver elektrostatisch abgeschieden und sodann über einen Zeitraum von 8 bis 30 Minuten in einem Temperaturbereich zwischen 120 °C und 240 °C eingebrannt wird.

Schließlich kann auf die Deckschicht eine kratzfeste Schutzschicht aufgebracht werden, die vorzugsweise aus einer Kohlenstoffverbindung besteht.

Die Erfindung wird nachstehend an Hand der nachfolgenden Beschreibung eines der Zeichnung zu entnehmenden bevorzugten Ausführungsbeispiels näher erläutert.

Es zeigen:

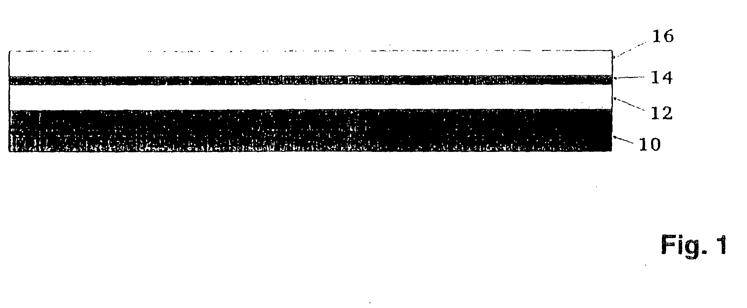

- Fig. 1: einen Schichtaufbau eines eine Glanzwirkung hervorrufenden Materials,
- Fig. 2: ein Verfahrensschema und
- Fig. 3: eine Prinzipdarstellung einer Plasmakammer.

Auf einem eine beliebige Geometrie aufweisenden Substrat (10) wird elektrostatisch ein Pulver aus einer Polyester-Harz-Verbindung aufgetragen und sodann bei einer Substrattemperatur von in etwa 120 °C bis 240 °C über eine Zeitdauer von 8 bis 30 Minuten eingebrannt, um eine Grundschicht (12) einer Dicke zwischen 25 µm und 125 µm zu erzielen. Auf diese Weise ist sichergestellt, daß ursprünglich möglicherweise vorhandene Oberflächenrauhigkeiten des Substrats (10) ausgeglichen sind. Alternativ oder ergänzend kann die Substratoberfläche gereinigt werden.

Das Substrat (10) kann aus einem grundsätzlich beliebigen Material wie Metall, Keramik, Glas oder Kunststoff bestehen, wobei selbstverständlich die Nebenbedingung erfüllt sein muß, daß bei der zur Anwendung gelangenden Einbrenntemperatur die erforderliche Formstabilität gewährleistet ist.

Sodann wird das Substrat (10) mit der Grundschicht in einen Reaktionsraum gebracht, der zunächst auf einen Druck zwischen 10⁻⁴ und 10⁻⁵ Millibar eingestellt wird. Auf diese Weise werden insbesondere Sauerstoff- und Stickstoff-Moleküle entfernt, die andernfalls zu einer unerwünschten Reaktion führen könnten.

Anschließend wird der Reaktionsraum mit einem Prozeßgas, vorzugsweise Argon geflutet, wobei sich ein Enddruck zwischen 1 und 10⁻³ Millibar einstellt.

Um auf Gegenständen einen Hochglanzeffekt zu erreichen, erfolgt nach dem Stand der Technik z. B. ein galvanisches Verchromen, Vernickeln oder Eloxieren. Hierbei sind aufwendige Vorbehandlungen des Grundmaterials notwendig wie z. B. Polieren der Oberfläche um den gewünschten Hochglanzeffekt zu erzielen. Darüber hinaus können bestimmte Materialien nicht dauerhaft hochglanzmetallisiert werden, so z. B. Chrom auf Aluminium, Entsprechende Verfahren zeigen zudem den Nachteil, daß sie zu einer hohen Umweltbelastung führen.

In das ausgebildete Plasma wird ein Metall wie Aluminium, Chrom, Titan, Silber oder Gold verdampft, um das in dem Reaktionsraum befindliche Substrat (10) zu beschichten, also die Grundschicht (12) bzw. das gereinigte Substrat mit der den Hochglanzmetalleffekt bewirkenden Schicht (14) zu versehen.

Nachdem die Schicht (14) aufgetragen ist, wird in einem weiteren Verfahrensschritt durch elektrostatische Pulverbeschichtung eine Deckschicht (16) aufgetragen, wobei der Verfahrensablauf demjenigen entspricht, der zur Ausbildung der Grundschicht (10) erfolgte. Auch sollte die Deckschicht (16) eine Dicke zwischen 25 µm und 125 µm aufweisen. Durch die Deckschicht (16) ist eine gute mechanische und chemische Beständigkeit gegeben.

Auf diese Weise beläuft sich die Dicke der Schichten (12), (14) und (16) insgesamt in etwa 50 µm bis 250 µm.

Um den Glanzeffekt in gewünschtem Umfang zu variieren, kann als Grundschicht (12) bzw. Deckschicht (16) ein matter oder glänzender Pulverlack verwendet werden, der für die Deckschicht (16) transparent oder farbig lasierend sein muß.

Gegebenenfalls kann in einem weiteren Verfahrensschritt eine nicht dargestellte Endschicht aufgetragen werden, die aus einer Kohlenstoffverbindung besteht und hoch kratzfest ist.

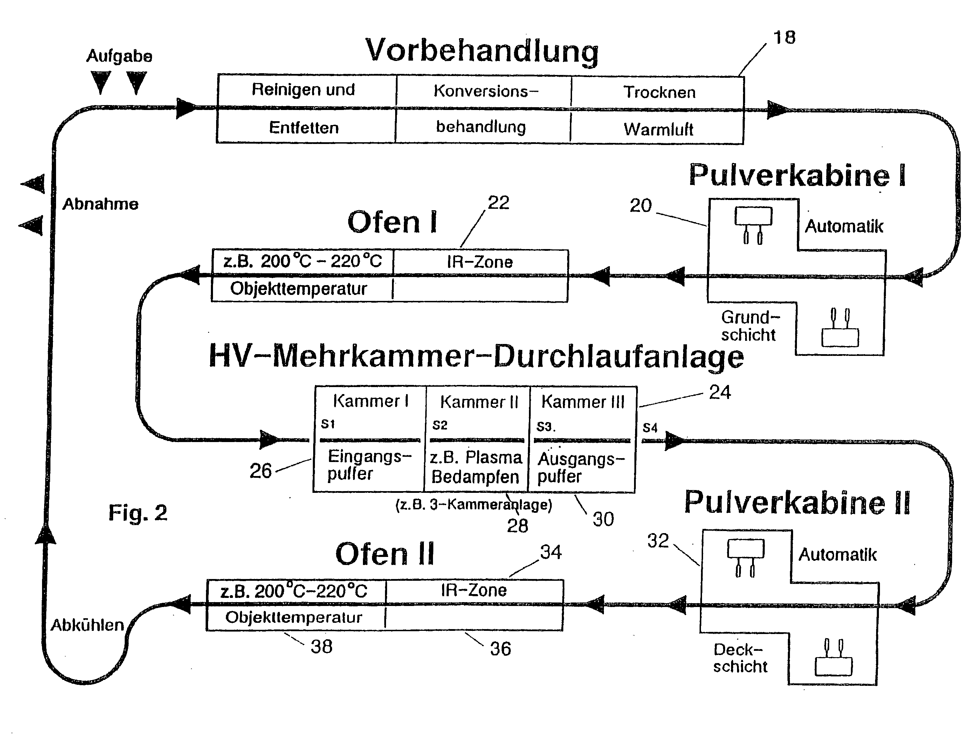

In Fig. 2 ist ein Verfahrensschema einer Durchlaufanlage für die Beschichtung von Formkörpern wie z.B. Felgen dargestellt.

In einer mit dem Bezugszeichen (18) versehenen Vorbehandlungszone wird der aufgegebene Formkörper (Substrat (10)) gereinigt und entfettet, um diesen sodann einer Konversionsbehandlung zu unterziehen. Anschließend erfolgt ein Trocknen mit Warmluft. Sodann wird der Formkörper (10) einer Pulverkabine I (20) zugeführt, in der ein automatisches Auftragen der Grundschicht (12) vorzugsweise einer Pulverlackschicht erfolgt. Dieses Auftragen der Pulverlackschicht in der Pulverkabine 1 (20) kann elektrostatisch erfolgen.

Nach Verlassen der Pulverkabine I (20), wird der Formkörper (10) einem Ofen I (22) zugeführt, in dem zunächst eine IR-Zone durchfahren wird, um den Formkörper sodann auf eine gewünschte Substrattemperatur z.B. im Bereich zwischen 200 °C und 220 °C zu erhitzen.

Nachdem die Grundschicht (12) eingebrannt ist, wird eine HV-Mehrkammer-Durchlaufanlage (24) durchfahren, die im Ausführungsbeispiel aus den Kammern (26), (28) und (30) besteht. Die Kammer (26) stellt dabei einen Eingangspuffer und die Kammer (30) einen Ausgangspuffer dar. In der Kammer (28) erfolgt das eigentliche Auftragen mit dem die Glanzwirkung hervorrufenden Material, und zwar vorzugsweise durch Plasmabedampfen.

Nach Verlassen der Kammer (30) wird der Formkörper (10) einer Pulverkabine II (32) zugeführt, die eine Deckschicht (16) in Form einer Pulverlackschicht vorzugsweise durch elektrostatisches Abscheiden aufgebracht wird. Anschließend wird ein Ofen II (34) mit Infrarot-Zone (36) und Einbrennzone (38) durchlaufen, in der das Objekt (10) auf eine gewünschte Temperatur z. B. auf ca. 200 °C - 220°C erwärmt wird. Danach erfolgt ein Abkühlen des Objektes (10), um dem Kreislauf entnommen zu werden.

Die Hochvakuum-Mehrkammer-Durchlaufanlage (24) besteht aus z.B. den drei in den Abmessungen gleich großen Vakuumkammern (26), (28) und (30), welche durch Schleusen (51), (52), (53) und (54) voneinander getrennt sind. Die Formkörper (10) fahren zunächst durch die Schleuse (S1) in den Eingangspuffer (26). Diese wird auf den Druck evakuiert, der in der Prozeßkammer (28) eingestellt ist. Nach Erreichen dieses Drucks werden die Schleusen S2 und S3 geöffnet. Der in der Plasmakammer (28) befindliche Körper fährt nun in den Ausgangspuffer (30) und der im Eingangspuffer (26) befindliche in die Prozeßkammer (28). Anschließend werden die Schleusen (S2), (S3) geschlossen. Eingangs- und Ausgangspuffer (26) und (30) werden nun belüftet und anschließend die Schleusen (S1) und (S4) geöffnet. Der bedampfte Körper (10) kann nun aus dem Ausgangspuffer (30) ausfahren und der nächste Körper (10) in den Eingangspuffer (26) einfahren. Parallel hierzu wird bereits der in der Plasmakammer (28) befindliche Körper (10) bedampft.

Vorteil dieses Systems ist eine kürzere Taktzeit, da die Prozeßkammer (28) immer unter Vakuum gehalten wird und Arbeitsgänge wie Evakuieren, Belüften und Bedampfen parallel ablaufen können.

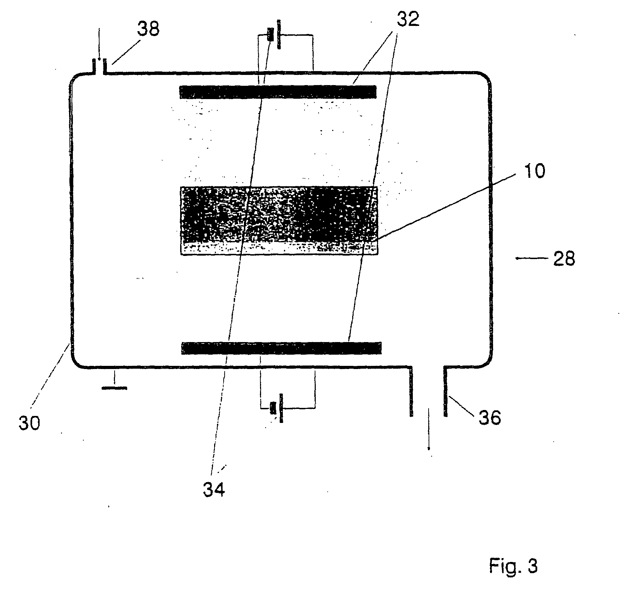

Der Fig. 3 ist ein Prinzipbild der Plasmakammer (28) zu entnehmen. Die Plasmakammer umfaßt ein Gehäuse (30), das geerdet ist und in dem das Substrat (10), das mit dem die Glanzwirkung hervorrufenden Material beschichtet werden soll, angeordnet ist. Dabei befindet sich das Substrat (10) zwischen Kathoden (32), die an den Minuspolen von Gleichspannungsquellen (34) anliegen.

Zwischen den Kathoden (32) und dem Substrat (10) kann sich sodann ein Plasma ausbilden.

Das Gehäuse (30) kann über einen Stutzen (36) mit einer Vakuumpumpe verbunden werden. Das erforderliche Prozeßgas selbst wird über den Anschluß (38) eingelassen.

## Patentansprüche

1. Verfahren zum Beschichten eines Substrats (10) mit einem eine Glanzwirkung hervorrufenden Metall, wobei das Substrat (10) aus einem geeigneten Material besteht, welches bis zumindest 120 °C formbeständig ist, umfassend die Verfahrensschritte in der nachstehenden unmittelbar aufeinanderfolgenden Abfolge
a') Aufbringen und Einbrennen einer Pulverlackschicht als Grundschicht (12) unmittelbar auf das Substrat,
b') Beschichten des grundbeschichteten Substrats (10) mit dem die Glanzwirkung hervorrufenden Metall in einer Vakuumkammer, in der ein Plasma-Prozeß stattfindet, und
c') anschließendes Aufbringen einer Pulverlackschicht als Deckschicht (16) und Einbrennen dieser.

2. Verfahren nach Anspruch 1,
**dadurch gekennzeichnet,**
**daß** die Grundschicht (12) in Form einer Pulverlackschicht bei einer Substrattemperatur von in etwa 120 °C bis 240 °C eingebrannt wird.

3. Verfahren nach Anspruch 2,
**dadurch gekennzeichnet,**
**daß** das Einbrennen der Pulverlackschicht über einen Zeitraum von in etwa 8 Minuten bis 30 Minuten erfolgt.

4. Verfahren nach einem der vorhergehenden Ansprüche,
**dadurch gekennzeichnet,**
**daß** das mit der Grundschicht (12) versehene Substrat (10) in einem Reaktionsraum (24) angeordnet wird, in dem zunächst ein Druck von zumindest 10⁻⁴ mbar herrscht, daß der Reaktionsraum anschließend mit Prozeßgas zum Einstellen eines Druckes P_{P} von in etwa 1 bis 10⁻³ Millibar geflutet wird und daß bei dem Druck P_{P} der Plasmaprozeßdurchgeführt wird.

5. Verfahren nach Anspruch 1,
**dadurch gekennzeichnet,**
**daß** die Deckschicht (16) bei einer Substrattemperatur von in etwa 120 °C bis 240 °C eingebrannt wird.

6. Verfahren nach Anspruch 5,
**dadurch gekennzeichnet,**
**daß** das Einbrennen der Deckschicht (16) über einen Zeitraum von in etwa 8 Minuten bis 30 Minuten erfolgt.

7. Verfahren nach einem der vorhergehenden Ansprüche,
**dadurch gekennzeichnet,**
**daß** für die Pulverlackschicht benötigtes Pulver elektrostatisch oder durch Sintern aufgebracht wird.

8. Verfahren nach einem der vorhergehenden Ansprüche,
**dadurch gekennzeichnet,**
**daß** die jeweilige Schichtdicke der Grundschicht (12) und/odar Deckschicht (16) in etwa 25 µm bis 125 µm beträgt.

9. Verfahren nach einem der vorhergehenden Ansprüche,
**dadurch gekennzeichnet,**
**daß** die auf das Substrat (10) aufgetragenen Schichten (12, 14, 16) eine Gesamtdicke von in etwa 50 µm bis 250 µm aufweisen.

10. Verfahren nach einem der vorhergehenden Ansprüche,
**dadurch gekennzeichnet,**
**daß** zur Erzeugung bzw. Induzierung von Plasma Hochfrequenz, Gleichspannung, Einfach- oder Doppelkathodenzerstäubung, Lichtbogenverdampfung oder Laser benutzt wird.

11. Verfahren nach Anspruch 4,
**dadurch gekennzeichnet,**
**daß** in dem Reaktionsraum (24) zunächst ein Druck zwischen 10⁻⁴ und 10⁻⁵ Millibar herrscht.

12. Verfahren nach Anspruch 7,
**dadurch gekennzeichnet,**
**daß** das Pulver im Wirbelsinterverfahren aufgebracht wird.

## Claims

1. A process for coating a substrate (10) with a metal giving a polished effect, the substrate (10) being of a suitable material that is dimensionally stable up to at least 120°C, said process comprising the process steps as described below following each other directly:
a') Applying and burning in a powder lacquer coating directly on the substrate as a base coating (12);
b') Coating the coated substrate (10) with the metal that gives the polished effect within a vacuum chamber, with which a plasma process takes place;
c') Application of a powder lacquer coating as a top coating (16) and burning this in.

2. A process as defined in Claim 1,
**characterized in that**
the base coating (12) is burned in the form of a powder lacquer coating at a substrate temperature of approximately 120°C to 240°C.

3. A process as defined in Claim 2,
**characterized in that**
the powder lacquer coating is burned in for a period of 8 minutes to 30 minutes.

4. A process as defined in one of the preceding Claims,
**characterized in that**
the substrate (10) that is provided with the base coating (12) is arranged within a reaction chamber (24) in which initially there is a pressure of at least 10⁻⁴ millibars; **in that** the reaction chamber is then flooded with process gas to produce a pressure P_{P} of approximately 1 to 10⁻³ millibars; and **in that** the plasma process takes place at the pressure P_{P}.

5. A process as defined in Claim 1,
**characterized in that**
the top coating (16) is burned in at a substrate temperature of approximately 120°C to 240°C.

6. A process as defined in Claim 5,
**characterized in that**
the top coating (16) is burned in for a period of approximately 8 minutes to 30 minutes.

7. A process as defined in one of the preceding Claims,
**characterized in that**
the powder that is required for the powder lacquer coating is applied electrostatically or by sintering.

8. A process as defined in one of the preceding Claims,
**characterized in that**
in each instance the thickness of the base coating (12) and/or top coating (16) is approximately 25 µm to 125 µm.

9. A process as defined in one of the preceding Claims,
**characterized in that**
the coatings (12, 14, 16) that are applied to the substrate (10) have a total thickness of approximately 50 µm to 250 µm.

10. A process as defined in one of the preceding Claims,
**characterized in that**
high frequency, direct current, single or double cathode vaporization, arc vaporization, or lasers are used to generate or induce the plasma.

11. A process as defined in Claim 4,
**characterized in that**
in the reaction chamber (24) there initially is a pressure of between 10⁻⁴ and 10⁻⁵ millibars.

12. A process as defined in Claim 7,
**characterized in that**
the powder is applied using the vortex sintering process.

## Revendications

1. Procédé pour revêtir un substrat (10) d'un métal provoquant un effet brillant, dans lequel le substrat est constitué d'un matériau adéquat gardant sa forme au moins jusqu'à une température de 120°C et qui comprend les étapes de procédé ayant lieu immédiatement les unes après les autres dans l'ordre suivant :
a) application et cuisson au four d'une couche de vernis en poudre comme couche de base (12) directement sur le substrat,
b) revêtement du substrat (10) ainsi revêtu par un métal provoquant l'effet brillant dans une chambre à vide à l'intérieur de laquelle a lieu un processus à plasma et
c) application d'une couche de vernis en poudre comme couche superficielle (16) et cuisson au four de celle-ci.

2. Procédé selon revendication 1
**caractérisé en ce que**
la couche de base (12) est appliquée sous forme d'une couche de vernis en poudre qui est ensuite cuite à une température du substrat située entre 120°C et 240°C environ.

3. Procédé selon revendication 2
**caractérisé en ce que**
la cuisson de la couche de vernis en poudre a lieu pendant une durée d'environ 8 minutes à 30 minutes.

4. Procédé selon une des revendications ci-dessus
**caractérisé en ce que**
le substrat (10) revêtu de la couche de base (12) est placé dans une chambre à réaction (24) dans laquelle règne une pression maximum de 10⁻⁴ millibar, et **en ce que** cette chambre est ensuite portée à l'aide d'un gaz process approprié à une pression P_{P} d'environ 1 à 10⁻³ millibar, et **en ce que** le processus à plasma se déroule à cette pression P_{P}.

5. Procédé selon revendication 1
**caractérisé en ce que**
la couche superficielle (16) est cuite à une température du substrat située entre 120°C et 240°C environ.

6. Procédé selon revendication 5
**caractérisé en ce que**
la cuisson de la couche superficielle (16) a lieu pendant une durée d'environ 8 minutes à 30 minutes.

7. Procédé selon une des revendications ci-dessus
**caractérisé en ce que**
la poudre nécessaire pour la couche de vernis en poudre est appliquée par un moyen électrostatique ou par frittage.

8. Procédé selon une des revendications ci-dessus
**caractérisé en ce que**
les épaisseurs de la couche de base (12) et/ou de la couche superficielle (16) sont d'environ 25 µm à 125 µm.

9. Procédé selon une des revendications ci-dessus
**caractérisé en ce que**
l'épaisseur cumulée des couches (12, 14, 16) appliquées sur le substrat (19) est d'environ 50 µm à 250 µm.

10. Procédé selon une des revendications ci-dessus
**caractérisé en ce que**
la production et/ou l'induction du plasma a lieu en utilisant une haute fréquence, une tension continue, une pulvérisation cathodique simple ou double, une évaporation par arc électrique ou un laser.

11. Procédé selon revendication 4
**caractérisé en ce que**
la pression qui règne initialement dans la chambre à réaction (24) est entre 10⁻⁴ et 10⁻⁵ millibars.

12. Procédé selon revendication 7
**caractérisé en ce que**
la poudre est appliquée par un procédé de frittage à lit fluidisé.
